# EUROPEAN PATENT APPLICATION

(11) **EP 4 579 663 A1**
(43) Date of publication of application: **02.07.2025**
(21) Application number: 24215435.9
(22) Date of filing: 26.11.2024
(51) Int. Cl.: G11C 5/14

(54) **MEMORY DEVICE FOR REDUCING LEAKAGE CURRENT**

(30) Priority: 12.12.2023 KR 20230180106
(71) Applicant: Samsung Electronics Co., Ltd., Suwon-si, Gyeonggi-do 16677 (KR)
(72) Inventor: LEE, Dongil, 16677 Suwon-si, Gyeonggi-do (KR); SEOL, Hoseok, 16677 Suwon-si, Gyeonggi-do (KR); KIM, Kiheung, 16677 Suwon-si, Gyeonggi-do (KR); HWANG, Hyongryol, 16677 Suwon-si, Gyeonggi-do (KR)
(74) Representative: Kuhnen & Wacker Patent- und Rechtsanwaltsbüro PartG mbB

(57) **Abstract**

A memory device for reducing leakage current is provided. The memory device includes a function circuit (300) including a plurality of semiconductor devices (30) and a body bias generator (150) that provides body bias voltages (VBB) to body terminals of the plurality of semiconductor devices (30). The function circuit (300) includes a first circuit (101), a second circuit (102), and first to fourth switches. The first switch (SW1) is connected between the first circuit (101) and a first node (N1) to which the body bias voltage is applied. The second switch (SW3) is connected between the second circuit (102) and a first node (N1). The third switch (SW2) is connected between the first circuit (101) and a second node (N2) to which a supply voltage (VDD) is applied. The fourth switch (SW4) is connected between the second circuit (102) and the second node (N2). The switches (SW1 to SW4) are controlled by a control signal (S_CTRL). The device threshold voltage is increased by the applied body bias voltage (VBB) thereby reducing leakage current.

## Description

### BACKGROUND

As the demand to speed up electronic systems, increase data capacity, and consume less power has increased, semiconductor memories that can be accessed faster, store more data, and use less power have been continuously developed.

### SUMMARY

This disclosure describes a memory device capable of reducing leakage current by increasing a threshold voltage by providing a reverse body bias (RBB) voltage to a circuit that is not used during a normal operation of the memory device.

A semiconductor memory device, such as a dynamic random access memory (DRAM), may include a voltage generator that generates a power voltage required for operation using an external voltage provided by an external host, and the voltage generator may generate bias voltages required for operations of multiple semiconductor devices included in the semiconductor device.

In general, a body bias is used to dynamically adjust a threshold voltage of a transistor. For example, a forward body bias (FBB) lowers the threshold voltage of the transistor, and a reverse body bias (RBB) increases the threshold voltage of the transistor. Here, the FBB is set to be lower than a normal body bias (NBB), and the RBB is set to be higher than the NBB.

In order to minimize specific distribution of the semiconductor devices, it is necessary to control the body bias voltage of the semiconductor devices.

A memory device is described including a function circuit including a plurality of semiconductor devices, and a body bias generator that provides body bias voltages to body terminals of the plurality of semiconductor devices, wherein the function circuit includes a first circuit, a second circuit, and first to fourth switches, wherein the first switch is connected between the first circuit and a first node to which the body bias voltage is applied, the second switch is connected between the second circuit and the first node, the third switch is connected between the first circuit and a second node to which a supply voltage is applied, and the fourth switch is connected between the second circuit and the second node.

A memory device is described including a function circuit including a plurality of semiconductor devices, and a body bias generator that provides body bias voltages to body terminals of the plurality of semiconductor devices, wherein the function circuit includes a first circuit, a second circuit, and first and second switches, wherein the first switch is connected between the first circuit and a first node to which the body bias voltage is applied, the second switch is connected between the first circuit and the second node to which a supply voltage is applied and the second circuit is connected to the second node.

A memory device is described including a data input/output circuit including a plurality of semiconductor devices and for transmitting and receiving 8-bit data, and a body bias generator that provides a body bias voltage to each of the semiconductor devices included in the data input/output circuit, wherein the data input/output circuit includes a first circuit, a second circuit, and first to fourth switches, wherein the first switch is connected between the first circuit and a first node to which the body bias voltage is applied, the second switch is connected between the second circuit and the first node, the third switch is connected between the first circuit and a second node to which a supply voltage is applied, and the fourth switch is connected between the second circuit and the second node.

### BRIEF DESCRIPTION OF THE DRAWINGS

Implementations will be more clearly understood from the following detailed description taken in conjunction with the accompanying drawings in which:
FIG. 1 is a block diagram illustrating an example memory system;
FIG. 2 is a block diagram specifically illustrating an example memory device;
FIG. 3 is a schematic block diagram illustrating the memory device of FIG. 2;
FIGS. 4 and 5 are circuit diagrams of semiconductor devices included in a memory device.
FIGS. 6 and 7 are cross-sectional views of the semiconductor devices illustrated in FIGS. 4 and 5;
FIG. 8 is a block diagram illustrating an example data input/output circuit;
FIG. 9 is a block diagram illustrating an operation of an example data input/output circuit;
FIG. 10 is a diagram illustrating a voltage level of an example data input/output circuit;
FIG. 11 is a block diagram illustrating an operation of an example data input/output circuit;
FIG. 12 is a diagram illustrating a voltage level of an example data input/output circuit;
FIG. 13 is a block diagram illustrating an operation of an example data input/output circuit;
FIG. 14 is a diagram illustrating a voltage level of an example data input/output circuit;
FIG. 15 is a block diagram illustrating an example memory device;
FIG. 16 is a diagram illustrating a voltage level of an example memory device;
FIG. 17 is a diagram illustrating an example semiconductor device; and
FIG. 18 is a block diagram illustrating an electronic device including an example memory device.

### DETAILED DESCRIPTION OF THE EMBODIMENTS

Hereinafter, implementations will be described in detail with reference to the accompanying drawings.

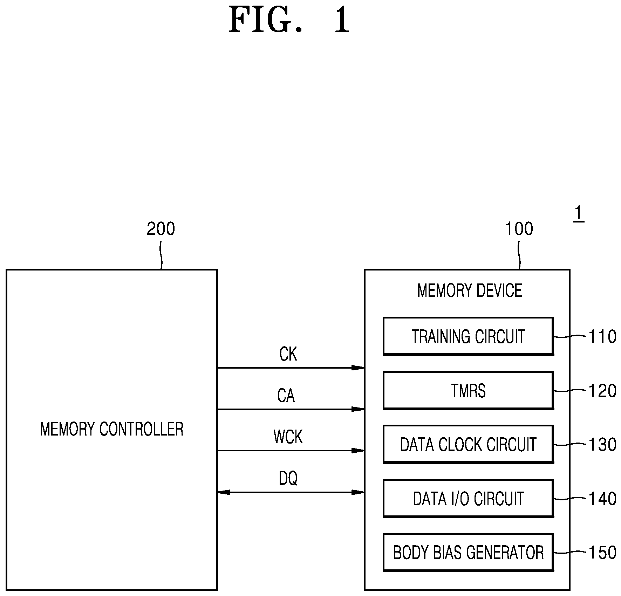

FIG. 1 is a block diagram illustrating a memory system 1.

Referring to FIG. 1, the memory system 1 may include a memory controller 200 and a memory device 100. The memory system 1 may be implemented to be included in a personal computer (PC) or a mobile electronic device. Mobile electronic devices may be implemented as laptop computers, mobile phones, smartphones, tablet PCs, personal digital assistants (PDAs), enterprise digital assistants (EDAs), digital still cameras, digital video cameras, Portable Multimedia Players (PMPs), Personal Navigation Devices (PNDs) or portable navigation devices, handheld game consoles, mobile Internet devices (MIDs), wearable computers, Internet of Things (IoT) devices, Internet of Everything (IoE) devices, or drones.

The memory controller 200 may control all operations of the memory device 100. For example, the memory controller 200 may control the memory device 100 so that data DQ is output from the memory device 100 or data DQ is stored in the memory device 100.

The memory controller 200 may transmit various signals to the memory device 100 and receive various signals from the memory device 100. For example, the memory controller 200 may transmit a command/address CA, a data clock signal WCK, a clock signal CK, and data DQ to the memory device 100 and receive data DQ from the memory device 100. The command/address CA may include a command CMD and/or an address ADD.

The memory controller 200 may be implemented as an integrated circuit (IC), a System on Chip (SoC), an Application Processor (AP), a mobile AP, a chipset, or a set of chips. As an example, the memory controller 200 may be a component included in an AP. The AP may include a memory controller, random access memory (RAM), a central processing unit (CPU), a graphics processing unit (GPU), and/or a modem.

The memory device 100 may be implemented as a volatile memory device. The volatile memory device may be implemented as RAM, dynamic RAM (DRAM), or static RAM (SRAM), but is not limited thereto. By way of example, the memory device 100 may correspond to Double Data Synchronous Dynamic Random Access Memory (DDR SDRAM), Low Power Double Data Rate (LPDDR) SDRAM, Graphics Double Data Rate (GDDR) SDRAM, Rambus Dynamic Random Access Memory (RDRAM), and the like. Alternatively, the memory device 100 may be implemented as a high bandwidth memory (HBM).

In addition, the memory device 100 may be implemented as a nonvolatile memory device. For example, the memory device 100 may be implemented as a resistive memory such as phase change RAM (PRAM), magnetic RAM (MRAM), resistive RAM (RRAM), and the like. The memory device 100 is illustrated as a single semiconductor chip, but in reality, n (n is an integer other than 0, and a non-zero whole number) memory devices may be included.

The memory device 100 may include a training circuit 110, a test mode register 120 (hereinafter referred to as "TMRS"), a data clock circuit 130, a data input/output (I/O) circuit 140, and a body bias generator 150.

The training circuit 110 may perform memory core parameter training associated with a memory core and/or peripheral circuit parameter training for peripheral circuits other than the memory core in the memory device 100, in response to a training command. The training circuit 110 may become a training subject to determine an optimal parameter for a memory core parameter and/or a peripheral circuit parameter. In an implementation, the training circuit 110 may be included in the memory device 100, but the training circuit 110 may be included in the memory controller 200.

The TMRS 120 may store information used to configure a test operation of the memory device 100 in order to set a test operation condition for the memory device 100. The TMRS 120 may be programmed by a test mode resistor set signal (not shown) to tune or calibrate various electrical parameters of the memory device 100. The TMRS 120 may be an extended register for testing various electrical parameters in a test mode of the memory system 1. The TMRS 120 may store information configuring the test operation in an anti-fuse manner.

The data clock circuit 130 may receive the data clock signal WCK from the memory controller 200. The data clock circuit 130 may provide the data clock signal WCK to the data input/output circuit 140.

The data input/output circuit 140 may transmit data DQ to the memory controller 200 and receive write data DQ synchronized with the timing-adjusted data clock signal WCK (from the memory controller 200. The data DQ transmitted and received by the data input/output circuit 140 may include an 8-bit data width or a 16-bit data width. The data width may be 16 bits, and 16 bits may be divided into a lower byte of 8-bit data and an upper byte of 8-bit data.

The body bias generator 150 may generate a body bias voltage. The body bias generator 150 may provide a body bias voltage to the training circuit 110, the TMRS 120, and/or the data input/output circuit 150 of the memory device 100. The body bias generator 150 may reduce leakage current flowing through the memory device 100 by adjusting the body bias voltage.

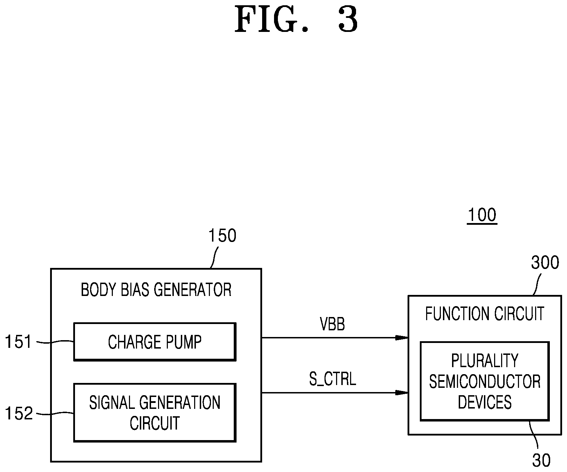

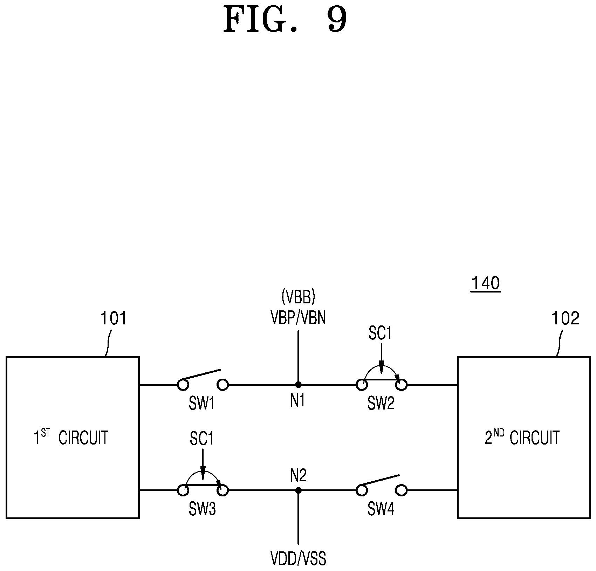

The configuration of the body bias generator 150 is described below with reference to FIG. 3. A method of reducing the leakage current of the memory device 100 by adjusting the body bias voltage of the body bias generator 150 is described in detail with reference to FIGS. 9 to 16.

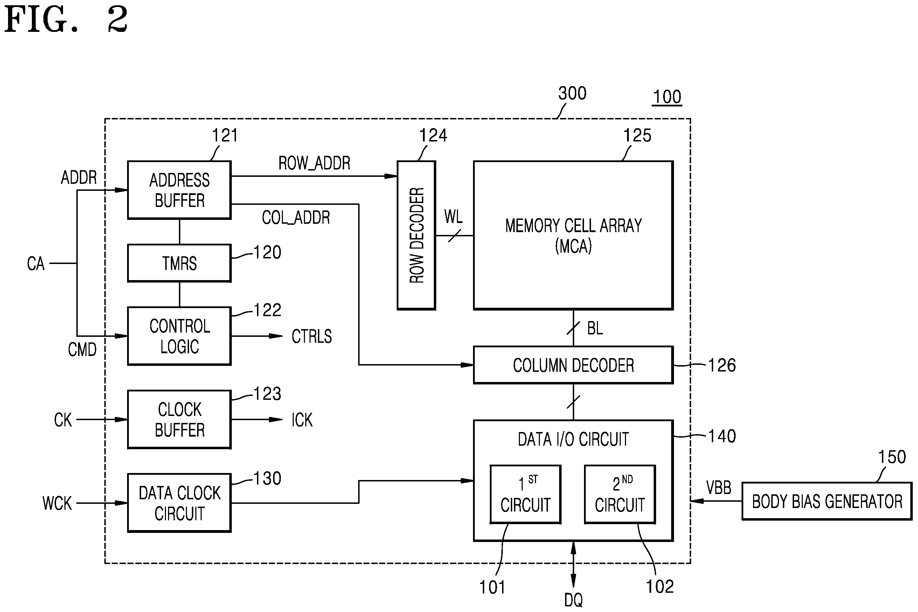

FIG. 2 is a block diagram illustrating a memory device 100. A redundant description with that of FIG. 1 is omitted.

Referring to FIGS. 1 and 2 together, the memory device 100 may include a function circuit 300 and a body bias generator 150. The function circuit 300 may perform various functions according to data or control signals provided to the memory device 100. The function circuit 300 may include circuits performing various functions. For example, the function circuit 300 may include, but is not limited to, a memory cell array 125, a row decoder 124, a column decoder 126, a clock buffer 123, a control logic 122, an address buffer 121, a TMRS 120, a data clock circuit 130, and a data input/output circuit 140.

The memory cell array 125 may include a plurality of memory cells provided in the form of a matrix arranged in rows and columns. The memory cell array 125 may include a plurality of word lines WL and a plurality of bit lines BL connected to the memory cells. The plurality of word lines WL may be connected to rows of the memory cells, and the plurality of bit lines BL may be connected to columns of the memory cells.

The row decoder 124 may select one of the plurality of word lines WL connected to the memory cell array 125. The row decoder 124 may decode a row address ROW_ADDR received through a command/address CA bus and the address buffer 121 to select any one word line WL corresponding to the row address ROW_ADDDR.

The column decoder 126 may select predetermined bit lines BL from among the plurality of bit lines BL of the memory cell array 125. The column decoder 126 may decode a column address COL_ADDR received from the address buffer 121 to generate a column selection signal and connect the bit lines BL selected by the column selection signal to the data input/output circuit 140.

The clock buffer 123 may receive a clock signal CK and generate an internal clock signal ICK. The internal clock signal ICK may be provided to the control logic 122 and may be used for various operation timings of the internal circuit.

The control logic 122 may receive a command CMD through the command/address (CA) bus, read data from the memory cell array 125 using control signals CTRLS for controlling the operation timing and/or memory operation of the memory device 100, and write data to the memory cell array 125. The control logic 122 provides control signals CTRLS to circuits of the memory device 100 to perform an operation stored by the TMRS 120 and operate as set in the control parameter.

The data input/output circuit 140 may include a first circuit 101 and a second circuit 102. The data DQ transmitted and received by the data input/output circuit 140 may include 8-bit data or 16-bit data.

In some implementations, when the data input/output circuit 140 transmits and receives an 8-bit wide data packet, either of the first circuit 101 or the second circuit 102 may not operate. A leakage current flowing through the memory device 100 may be reduced by applying a body bias voltage VBB to a circuit that is not operating.

By applying, based on a switch control signal, the body bias voltage VBB to a plurality of switches connected to the data input/output circuit 140, the leakage current of the data input/output circuit 140 may be reduced as described below with reference to FIGS. 9 to 14.

A body bias generator 150 may provide the body bias voltage VBB to the function circuit 300. The body bias voltage VBB may be a voltage provided to a transistor body terminal of the function circuit 300. The body bias generator 150 may adjust the body bias voltage VBB based on the switch control signal. The body bias voltage VBB may include a PMOS body bias voltage for a voltage applied to a PMOS body terminal, and an NMOS body bias voltage for a voltage applied to an NMOS body terminal.

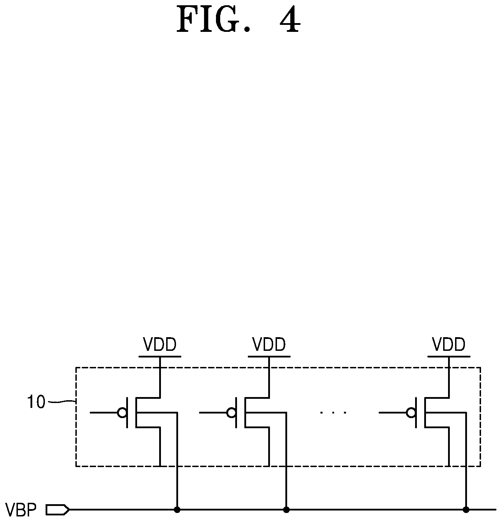

The function circuit 300 may include a plurality of transistors. A transistor may be one of the smallest logic units constituting the function circuit 300. For example, the transistor may include a P-channel metal oxide semiconductor device (PMOS) or an N-channel metal oxide semiconductor device (NMOS). The plurality of transistors constituting the function circuit 300 are described below with reference to FIGS. 4 to 7.

FIG. 3 is a schematic block diagram illustrating the memory device 100 of FIG. 2.

Referring to FIG. 3, the body bias generator 150 may include a charge pump 151 and a signal generation circuit 152. The function circuit 300 may include a plurality of semiconductor devices 30.

The body bias voltage VBB generated by the body bias generator 150 may be provided to the plurality of semiconductor devices 30 included in the function circuit 300. For example, the body bias voltage VBB may provide a body bias voltage VBB to body terminals of the plurality of semiconductor devices 30.

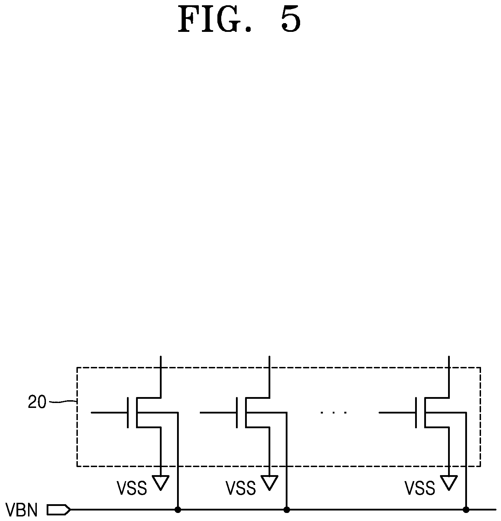

The charge pump 151 may output the body bias voltages VBB input to the body terminals of the plurality of semiconductor devices 30. For example, the charge pump 151 may include a positive charge pump circuit and a negative charge pump circuit. The body bias voltages VBB may include a PMOS body bias voltage VBP (see FIG. 4) that is a positive bias voltage and an NMOS body bias voltage VBN (see FIG. 5) that is a negative bias voltage. The positive charge pump circuit may output a PMOS body bias voltage VBP, and the negative charge pump circuit may output an NMOS body bias voltage VBN. For example, the PMOS body bias voltage VBP may refer to a voltage applied to the body terminal of a PMOS 10, and the NMOS body bias voltage VBN may refer to a voltage applied to the body terminal of an NMOS 20. For example, when the body bias voltage VBB is positive, the body bias voltage VBB may be input to the body terminal of the PMOS 10, and when the body bias voltage VBB is negative, the body bias voltage VBB may be input to the body terminal of the NMOS 20.

The signal generation circuit 152 may generate switch control signals S_CTRL for controlling the plurality of semiconductor devices 30. The signal generation circuit 152 may generate a switch control signal S_CTRL for controlling turning on and turning off each of the plurality of semiconductor devices 30 included in the function circuit 300. The switch control signal S_CTRL may include a first switch control signal, a second switch control signal, a third switch control signal, a fourth switch control signal, and an inversion of the fourth switch control signal (.i.e., a fourth switch inversion control signal).

In an implementation, the signal generation circuit 152 is shown to be included in the body bias generator 150, but the location is not limited thereto, and the memory controller 200 may include the signal generation circuit 152, and the memory controller 200 may provide the switch control signal S_CTRL to the memory device 100.

The plurality of semiconductor devices 30 may include a plurality of transistors. A transistor may be one of the smallest logic units. For example, the transistor may include a PMOS or an NMOS.

As described above, in some implementations, the body bias generator 150 may adjust the body bias voltage VBB provided to the function circuit 300 and/or the plurality of semiconductor devices 30. Accordingly, a leakage current of the memory device 100 may be reduced, and the reliability of the memory device 100 may thereby be improved.

FIGS. 4 and 5 are circuit diagrams of semiconductor devices included in a memory device. FIG. 4 is a PMOS circuit diagram, and FIG. 5 is an NMOS circuit diagram.

In some implementations, a PMOSFET may refer to a PMOS, a P-type transistor, and a PMOS device, and an NMOSFET may refer to an NMOS, an N-type transistor, and an NMOS device.

Referring to FIG. 4, one end (i.e., source or drain) of the PMOS 10 may be connected to a signal line or to one end (i.e., source or drain) of another transistor. Accordingly, various voltages may be provided to one end of the PMOS 10. The gate of the PMOS 10 may be connected to a signal line or a terminal of another transistor. Accordingly, various voltages may be provided to the gate of the PMOS 10. A body terminal of the PMOS 10 may be connected to a signal line to which the PMOS body bias voltage VBP is provided. Accordingly, the PMOS body bias voltage VBP provided from the body bias generator may be provided to the body terminal of the PMOS 10.

The PMOS body bias voltage VBP may be a positive voltage having a positive sign. A threshold voltage of the PMOS 10 may be determined according to a source-body voltage that is the difference between a source bias voltage input to a source terminal and the PMOS body bias voltage VBP input to the body terminal. For example, when the source-body voltage increases, the threshold voltage increases, and when the source-body bias voltage decreases, the threshold voltage may decrease.

The source terminal of the PMOS 10 may receive the power supply voltage VDD, and the body terminal of the PMOS 10 may receive the PMOS body bias voltage VBP. As the PMOS body bias voltage VBP is greater than the power supply voltage VDD, the threshold voltage of the PMOS 10 may increase and the current flowing through the PMOS 10 in the turn-on state may decrease. That is, when the PMOS body bias voltage VBP is higher than the power supply voltage VDD, the threshold voltage of the PMOS 10 may increase, and thus the leakage current of the PMOS 10 may decrease.

Referring to FIG. 5, one end (i.e., source or drain) of the NMOS 20 may be connected to a signal line or to one end (i.e., source or drain) of another transistor. Accordingly, various voltages may be provided to one end of the NMOS 20. The gate of the NMOS 20 may be connected to a signal line or a terminal of another transistor. Accordingly, various voltages may be provided to the gate of the NMOS 20. A body terminal of the NMOS 20 may be connected to a signal line to which the NMOS body bias voltage VBN is provided. Accordingly, the NMOS body bias voltage VBN provided from the body bias generator may be provided to the body terminal of the NMOS 20.

The NMOS body bias voltage VBN may be a negative voltage having a negative sign. In some implementations, the PMOS body bias voltage VBP and the NMOS body bias voltage VBN may have different signs. A threshold voltage of the NMOS 20 may be determined according to a source-body voltage that is the difference between a source bias voltage input to a source terminal and the NMOS body bias voltage VBN input to the body terminal. For example, when the source-body voltage increases, the threshold voltage increases, and when the source-body bias voltage decreases, the threshold voltage may decrease.

The source terminal of the NMOS 20 may receive the ground voltage VSS, and the body terminal may receive the NMOS body bias voltage VBN. In other words, as the NMOS body bias voltage VBN having a negative sign is lower than the ground voltage VSS, the threshold voltage of the NMOS 20 may increase and the current flowing through the NMOS 20 in the turn-on state may decrease. That is, when the NMOS body bias voltage VBN is lower than the ground voltage VSS, the threshold voltage of the NMOS 20 may increase, and thus the leakage current of the NMOS 20 may decrease.

Referring to FIGS. 4 and 5, by adjusting the PMOS body bias voltage VBP and/or the NMOS body bias voltage VBN, each threshold voltage of the PMOS 10 and/or the NMOS 20 may be adjusted, and the amount of current flowing through each device in the turn-on state may also be adjusted. The characteristics of the PMOS 10 and/or the NMOS 20 may change depending on process deviations occurring in the manufacturing process of semiconductor devices including the PMOS 10 and/or the NMOS 20, on the magnitude of the external power voltage input to the semiconductor device from an external host or power device, and on the internal and external temperatures of the semiconductor device, and thus the deviation of the characteristics of the PMOS 10 and/or the NMOS 20 may increase.

In some implementations, the PMOS and NMOS body bias voltages VBP and VBN input to the body terminals of the PMOS 10 and/or the NMOS 20 may be adjusted to minimize deviation in characteristics of the PMOS 10 and/or the NMOS 20. Therefore, the performance of the semiconductor device or memory device may be improved by adjusting the characteristics of the PMOS 10 and/or NMOS 20, for example, threshold voltage or leakage current.

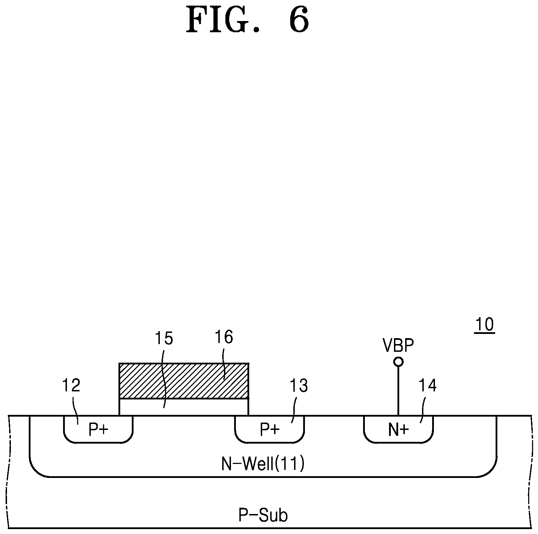

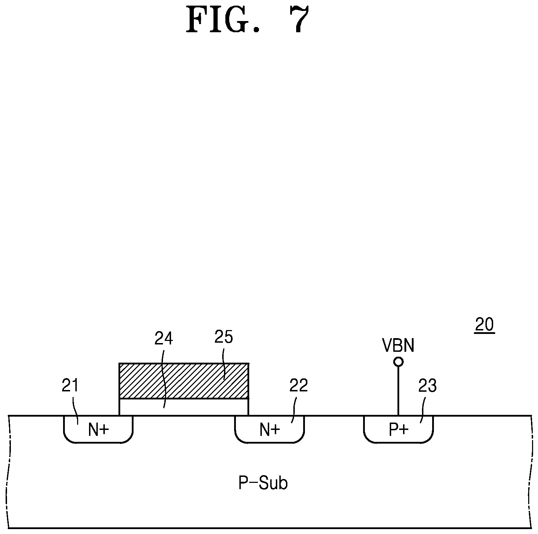

FIGS. 6 and 7 are cross-sectional views of the semiconductor devices 10 and 20 illustrated in FIGS. 4 and 5. FIG. 6 is a cross-sectional view of the PMOS 10, and FIG. 7 is a cross-sectional view of the NMOS 20.

Referring to FIG. 6, an N-well 11 may be formed on a P-type substrate P-Sub to form a PMOS 10. The N-well 11 may be formed by injecting an N-type dopant into a P-type substrate P-Sub. P+ doped regions 12 and 13 constituting a drain or source of the PMOS 10 may be formed on the N-well 11. An N+ doped region 14 for providing the PMOS body bias voltage VBP may be formed in the N-well 11. Subsequently, a gate insulating layer 15 and a gate electrode 16 may be sequentially stacked. The gate insulating layer 15 may include an oxide film, a nitride film, or a laminated film in which an oxide film and a nitride film are stacked. The gate electrode 16 may include a polysilicon layer or a metal layer doped with impurity ions (e.g., P, As, B, etc.).

In the structure of the PMOS 10, a gate voltage may be applied to the gate electrode 16 of the PMOS 10, and a drain voltage and a source voltage may be applied to the P+ doped regions 12 and 13 constituting the drain terminal and the source terminal, respectively. In addition, the PMOS body bias voltage VBP may be applied to the N+ doped region 14 constituting the body electrode of the PMOS 10.

Referring to FIG. 7, N+ doped regions 21 and 22 constituting a drain or a source may be formed on the P-type substrate P-Sub to form the NMOS 20. A P+ doped region 23 for providing the NMOS body bias voltage VBN may be formed on the P-type substrate P-sub. Subsequently, a gate insulating layer 24 and a gate electrode 25 may be sequentially stacked.

In the structure of the NMOS 20, a gate voltage may be applied to the gate electrode 25 of the NMOS 20, and a drain voltage and a source voltage may be applied to the N+ doped regions 21 and 22 constituting the drain terminal and source terminal, respectively. In addition, the NMOS body bias voltage VBN may be applied to the P+ doped region 23 constituting the body electrode of the NMOS 20.

Referring to FIGS. 6 and 7 together, as described above, the body bias voltage VBB provided from the body bias generator 150 may be provided to the bodies of the PMOS 10 and the NMOS 20. The body bias generator 150 may adjust the threshold voltages of the PMOS 10 and the NMOS 20 by adjusting the body bias voltage VBB. The leakage current flowing through the PMOS 10 and the NMOS 20 may vary according to the threshold voltage. Therefore, when the body bias voltage VBB is adjusted, the leakage current flowing through the PMOS 10 and the NMOS 20 may be adjusted. For example, when the body bias voltage VBB is lowered, threshold voltages of the PMOS 10 and the NMOS 20 may be increased. Accordingly, leakage current flowing through the PMOS 10 and the NMOS 20 may be reduced.

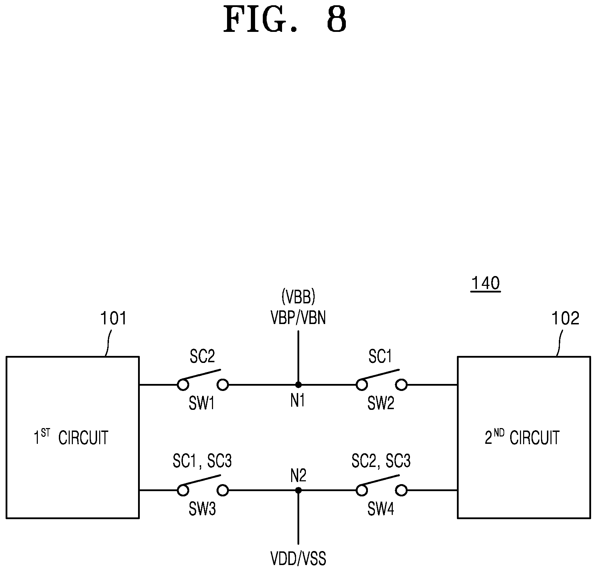

FIG. 8 is a block diagram illustrating an example data input/output circuit 140.

The data input/output circuit 140 may include a first circuit 101, a second circuit 102, and first to fourth switches SW1 to SW4. The first circuit 101 and the second circuit 102 may include PMOS and NMOS, which include a plurality of semiconductor devices as shown in FIGS. 4 to 7. The first to fourth switches SW1 to SW4 may be turned on and/or turned off in response to switch control signals.

For example, the data input/output circuit 140 may receive 8-bit data and 16-bit data. When the data input/output circuit 140 transmits or receives 8-bit data, only one of the first circuit 101 and the second circuit 102 may operate. Here, the operation of the circuit may mean receiving a power supply voltage VDD and a ground voltage VSS, which are supply voltages from a voltage generator or an external power source, and the non-operation of the circuit may mean receiving a body bias voltage VBB from the body bias generator 150. A method in which the first circuit 101 and the second circuit 102 operate by controlling the first to fourth switches SW1 to SW4 is described below with reference to FIGS. 9 to 14.

In some implementations, when the data input/output circuit 140 transmits and receives 8-bit data, the first circuit 101 may operate and the second circuit 102 may not operate. In this case, the third switch SW3 (which may be an example of the second switch in the appended claims) connected to the first circuit 101 is turned on to receive a power supply voltage VDD and a ground voltage VSS, which are supply voltages, and the second switch SW2 (which may be an example of the third switch in the appended claims) connected to the second circuit 102 is turned on to receive a PMOS body bias voltage VBP and an NMOS body bias voltage VBN, which are body bias voltages VBB output from the body bias generator 150.

On the contrary, for example, when the data input/output circuit 140 transmits and receives 8-bit data, the first circuit 101 may not operate and the second circuit 102 may operate. In this case, the first switch SW1 connected to the first circuit 101 may be turned on to receive a PMOS body bias voltage VBP and an NMOS body bias voltage VBN, which are body bias voltages VBB output from the body bias generator 150, and the fourth switch SW4 connected to the second circuit 102 may be turned on to receive a power supply voltage VDD and a ground voltage VSS, which are supply voltages.

The first circuit 101 may be connected to an end of the first switch SW1 and may be connected to an end of the third switch SW3. The second circuit 102 may be connected to an end of the second switch SW2 and may be connected to an end of the fourth switch SW4.

One end of the first switch SW1 may be connected to the first node N1, and the other end thereof may be connected to the first circuit 101. The first switch SW1 may be turned on in response to a first logic level (e.g., a logic high level) of the second switch control signal SC2. When the first switch SW1 is turned on, the first circuit 101 and the body bias generator may be electrically connected to each other. For example, when the first switch SW1 is turned on, the body bias voltage VBB may be applied to the body terminals of the semiconductor devices of the first circuit 101. That is, the first node N1 may output a PMOS body bias voltage VBP and an NMOS body bias voltage VBN, which are body bias voltages VBB.

One end of the second switch SW2 may be connected to the first node N1, and the other end thereof may be connected to the second circuit 102. The second switch SW2 may be turned on in response to the first logic level of the first switch control signal SC1. When the second switch SW2 is turned on, the second circuit 102 and the body bias generator may be electrically connected to each other. For example, when the second switch SW2 is turned on, a PMOS body bias voltage VBP and an NMOS body bias voltage VBN, which are body bias voltages VBB, may be applied to body terminals of semiconductor devices of the second circuit 102.

One end of the third switch SW3 may be connected to the second node N2, and the other end thereof may be connected to the first circuit 101. The third switch SW3 may be turned on in response to the first logic level of the first switch control signal SC1. In addition, the third switch SW3 may be turned on in response to the first logic level of the third switch control signal SC3. As the third switch SW3 is turned on, the first circuit 101 and the voltage generator may be electrically connected to each other. For example, when the third switch SW3 is turned on, a power supply voltage VDD and/or a ground voltage VSS may be applied to the semiconductor devices of the first circuit 101. The second node N2 may output a power supply voltage VDD and/or a ground voltage VSS.

One end of the fourth switch SW4 may be connected to the second node N2, and the other end thereof may be connected to the second circuit 102. The fourth switch SW4 may be turned on in response to the first logic level of the second switch control signal SC2. In addition, the fourth switch SW4 may be turned on in response to the first logic level of the third switch control signal SC3. As the fourth switch SW4 is turned on, the second circuit 102 and the voltage generator may be electrically connected to each other. For example, when the fourth switch SW4 is turned on, a power supply voltage VDD and/or a ground voltage VSS may be applied to the semiconductor devices of the second circuit 102.

In general, a body bias voltage may be used to dynamically adjust threshold voltages of a plurality of transistors included in the first circuit 101 and the second circuit 102. For example, a reverse body bias may increase threshold voltages of multiple transistors. Here, the reverse body bias may be set to be higher than a normal body bias.

In some implementations, a power supply voltage VDD and/or a ground voltage VSS may be applied to semiconductor devices of an operating circuit of the data input/output circuit 140, and a body bias voltage VBB, which is a PMOS body bias voltage VBP and an NMOS body bias voltage VBN, may be applied to semiconductor devices of a non-operating circuit of the data input/output circuit 140. The level of the PMOS body bias voltage VBNP may be set to be higher than the level of the power supply voltage VDD, and the level of the NMOS body bias voltage VBN may be set to be lower than the level of the ground voltage VSS. By applying a PMOS body bias voltage VBP and an NMOS body bias voltage VBN to semiconductor devices in a non-operating circuit of the data input/output circuit 140, i.e., by applying a reverse body bias voltage to semiconductor devices in a non-operating circuit of the data input/output circuit 140 to increase a threshold voltage, leakage current flowing to semiconductor devices in the non-operating circuit may be reduced.

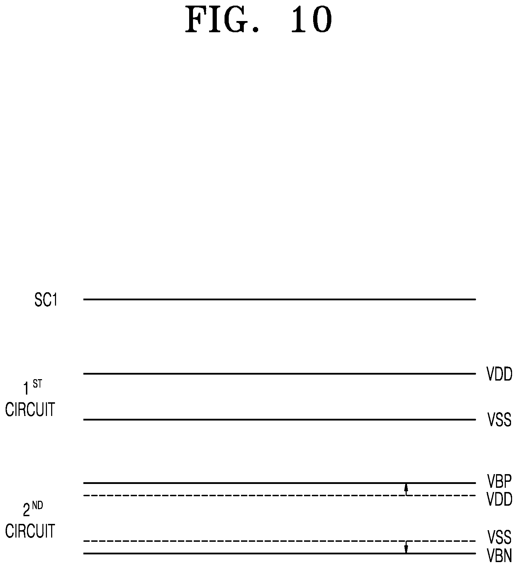

FIG. 9 is a block diagram illustrating an operation of an example data input/output circuit 140. FIG. 10 is a diagram illustrating a voltage level of an example data input/output circuit 140. A redundant description of FIG. 9 that is substantially the same as that of FIG. 8 is omitted.

Referring to FIG. 9, when the data input/output circuit 140 transmits or receives 8-bit data, it will be described on the assumption that the first circuit 101 operates and the second circuit 102 does not operate.

The third switch SW3 (which may be an example of the second switch in the appended claims) connected to the first circuit 101 may be turned on by the first switch control signal SC1. The second switch SW2 (which may be an example of the third switch in the appended claims) connected to the second circuit 102 may be turned on by the first switch control signal SC1. The first switch SW1 and the fourth switch SW4 may not respond to the first switch control signal SC1 and thus may be in a turned-off state.

When the third switch SW3 is turned on, the power voltage VDD and the ground voltage VSS output through the second node N2 may be applied to the first circuit 101. For example, the power supply voltage VDD and the ground voltage VSS may be applied to the plurality of semiconductor devices included in the first circuit 101.

When the second switch SW2 is turned on, the PMOS body bias voltage VBP and the NMOS body bias voltage VBN output through the first node N1 may be applied to the second circuit 102. For example, the PMOS body bias voltage VBP and the NMOS body bias voltage VBN may be applied to the body terminals of the plurality of semiconductor devices included in the second circuit 102.

Referring to FIG. 10, the first switch control signal SC1 may have a first logic level (e.g., a high logic level). The first circuit 101 may have a logic level of the power supply voltage VDD and a logic level of the ground voltage VSS. The second circuit 102 may have a logic level of the PMOS body bias voltage VBP and a logic level of the NMOS body bias voltage VBN. Here, the voltage level of the PMOS body bias voltage VBP may be higher than the voltage level of the power supply voltage VDD, and the voltage level of the NMOS body bias voltage VBN may be lower than the voltage level of the ground voltage VSS.

Referring back to FIGS. 9 and 10, the PMOS body bias voltage VBP having a voltage level higher than the power supply voltage VDD may be applied to body terminals of any of the plurality of semiconductor devices of the second circuit 102, which are not operating, and the NMOS body bias voltage VBN having a voltage level lower than the ground voltage VSS may be applied thereto. That is, threshold voltages of the plurality of semiconductor devices included in the second circuit 102 may be adjusted by adjusting the PMOS body bias voltage VBP and the NMOS body bias voltage VBN. When the level of the PMOS body bias voltage VBP is set to be higher than the level of the power supply voltage VDD and the level of the NMOS body bias voltage VBN is set to be lower than the level of the ground voltage VSS, the leakage current flowing through the plurality of semiconductor devices of the second circuit 102 may decrease as the threshold voltage increases.

The leakage current flowing through the data input/output circuit 140 or the function circuit 300 of FIGS. 2 and 3 may be reduced by adjusting the body bias voltage VBB. Therefore, data errors caused by a decrease in read or write current according to a leakage current during a read or write operation may be reduced.

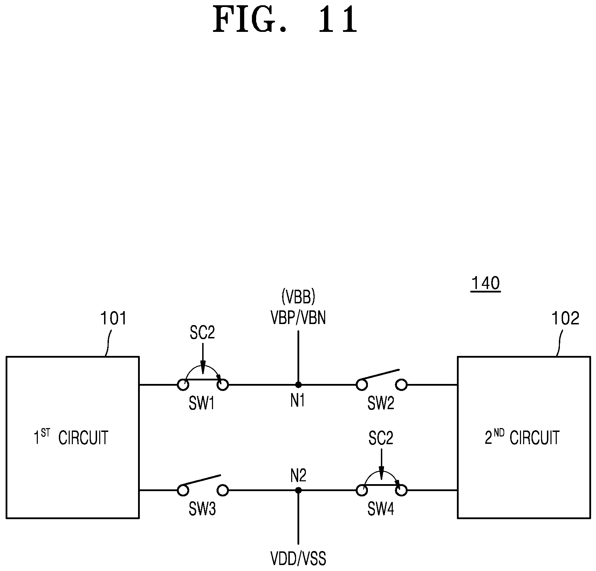

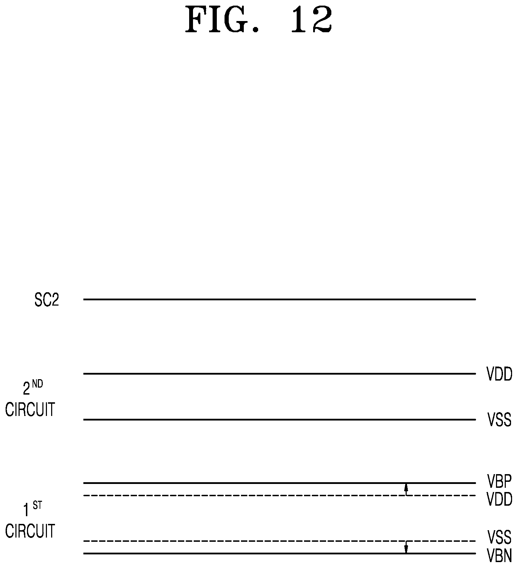

FIG. 11 is a block diagram illustrating an operation of an example data input/output circuit 140. FIG. 12 is a diagram illustrating a voltage level of an example data input/output circuit 140. A redundant description with that of FIGS. 9 and 10 is omitted.

Referring to FIG. 11, when the data input/output circuit 140 transmits or receives 8-bit data, the implementation will be described on the assumption that the first circuit 101 does not operate and the second circuit 102 operates.

The first switch SW1 connected to the first circuit 101 may be turned on by the second switch control signal SC2. The fourth switch SW4 connected to the second circuit 102 may be turned on by the second switch control signal SC2. The second switch SW2 (which may be an example of the third switch in the appended claims) and the third switch SW3 (which may be an example of the second switch in the appended claims) may not respond to the second switch control signal SC2 and thus may be in a turned-off state.

When the first switch SW1 is turned on, the PMOS body bias voltage VBP and the NMOS body bias voltage VBN output through the first node N1 may be applied to the first circuit 101. For example, the PMOS body bias voltage VBP and the NMOS body bias voltage VBN may be applied to the body terminals of the plurality of semiconductor devices included in the first circuit 101.

When the fourth switch SW4 is turned on, the power voltage VDD and the ground voltage VSS output through the second node N2 may be applied to the second circuit 102. For example, the power supply voltage VDD and the ground voltage VSS may be applied to the plurality of semiconductor devices included in the second circuit 102.

Referring to FIG. 12, the second switch signal SC2 may have a first logic level (e.g., a high logic level). The second circuit 102 may have a logic level of the power supply voltage VDD and a logic level of the ground voltage VSS. The first circuit 101 may have a logic level of the PMOS body bias voltage VBP and a logic level of the NMOS body bias voltage VBN.

Referring back to FIGS. 11 and 12, the PMOS body bias voltage VBP having a voltage level higher than the power supply voltage VDD may be applied to body terminals of the plurality of semiconductor devices of the first circuit 101, which are not operating, and the NMOS body bias voltage VBN having a voltage level lower than the ground voltage VSS may be applied thereto. That is, threshold voltages of the plurality of semiconductor devices included in the first circuit 101 may be adjusted by adjusting the PMOS body bias voltage VBP and the NMOS body bias voltage VBN. When the level of the PMOS body bias voltage VBP is set to be higher than the level of the power supply voltage VDD and the level of the NMOS body bias voltage VBN is set to be lower than the level of the ground voltage VSS, the leakage current flowing through the plurality of semiconductor devices of the first circuit 101 may decrease as the threshold voltage increases.

The leakage current flowing through the data input/output circuit 140 (see FIG. 2) or the memory cell array 125 (see FIG. 2) may be reduced by adjusting the body bias voltage VBB. Therefore, data errors may be reduced because there is a lower leakage current resulting in less variation in a read or write current.

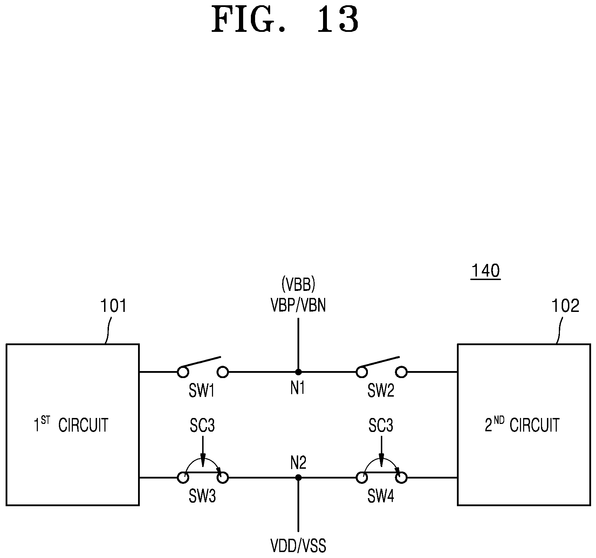

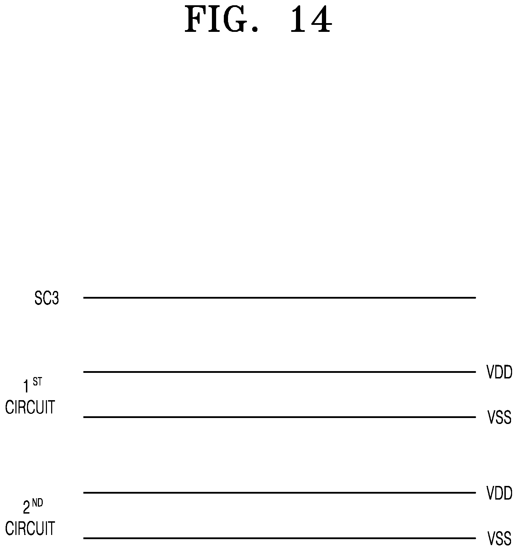

FIG. 13 is a block diagram illustrating an operation of an example data input/output circuit; FIG. 14 is a diagram illustrating a voltage level. A redundant description with that of FIGS. 9 and 10 is omitted.

Referring to FIG. 13, when the data input/output circuit 140 transmits/receives 16-bit data, the implementation will be described on the assumption that both the first circuit 101 and the second circuit 102 operate.

The third switch SW3 (which may be an example of the second switch in the appended claims) connected to the first circuit 101 may be turned on by the third switch control signal SC3. The fourth switch SW4 connected to the second circuit 102 may be turned on by the third switch control signal SC3. The first switch SW1 and the second switch SW2 (which may be an example of the third switch in the appended claims) may not respond to the third switch control signal SC3 and thus may be in a turned-off state.

When the third switch SW3 is turned on, the power voltage VDD and the ground voltage VSS output through the second node N2 may be applied to the first circuit 101. For example, the power supply voltage VDD and the ground voltage VSS may be applied to the plurality of semiconductor devices included in the first circuit 101.

When the fourth switch SW4 is turned on, the power voltage VDD and the ground voltage VSS output through the second node N2 may be applied to the second circuit 102. For example, the power supply voltage VDD and the ground voltage VSS may be applied to the plurality of semiconductor devices included in the second circuit 102.

Referring to FIG. 14, the third switch control signal SC3 may have a first logic level (e.g., a high logic level). The first circuit 101 and the second circuit 102 may have a logic level of the power supply voltage VDD and a logic level of the ground voltage VSS.

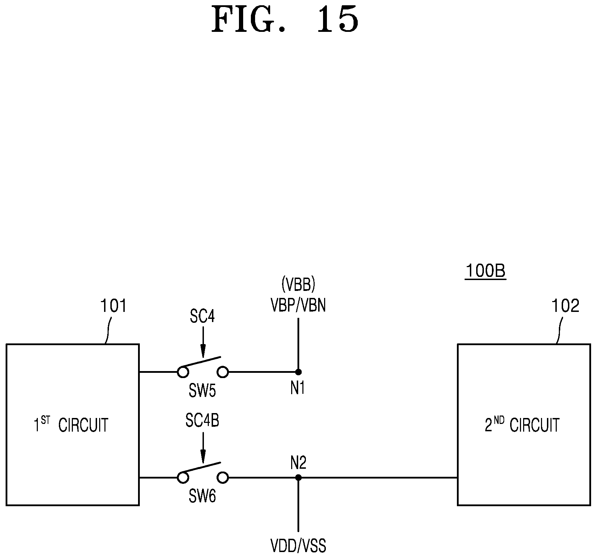

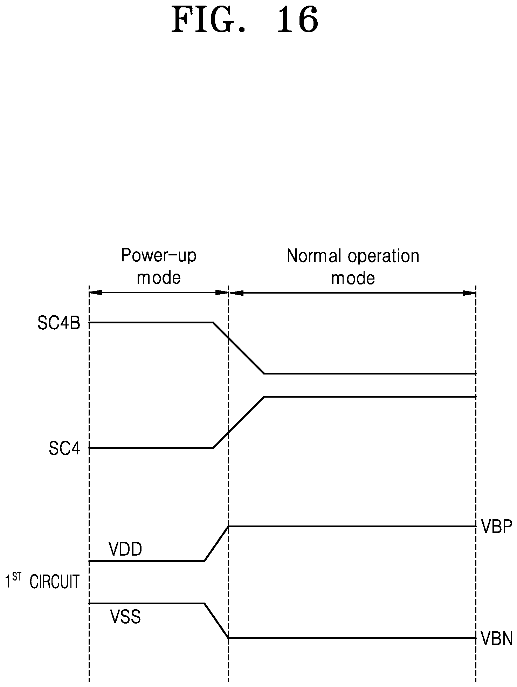

FIG. 15 is a diagram illustrating an operation of an example memory device 100B. FIG. 16 is a diagram illustrating a voltage level of a memory device 100B.

The memory device 100B illustrated in FIG. 15 may correspond to the memory devices 100 illustrated in FIGS. 1 and 2. The memory device 100B may include a first circuit 101, a second circuit 102, a first switch SW5, and a second switch SW6. The first circuit 101 and the second circuit 102 may include a PMOS and an NMOS, which are the plurality of semiconductor devices shown in FIGS. 4 to 7. The first switch SW5 and the second switch SW6 may be turned on and/or turned off in response to the switch control signals S_CTRL.

Here, the first circuit 101 may be a circuit in which the memory device 100 operates only in a power-up mode and may be a circuit in which the memory device 100 does not operate in a normal mode other than the power-up mode. For example, the first circuit 101 may be the TMRS 120 illustrated in FIG. 2 or the training circuit 110 illustrated in FIG. 1, and the second circuit 102 may be a circuit constituting the memory device 100 except for the first circuit 101. Here, since the first circuit 101 is used only in the power-up mode and is not used in the normal mode, the first circuit 101 may be referred to as an unused circuit, and the second circuit 102 may be referred to as a normal operation circuit or a use circuit. The unused circuit, which is the first circuit 101, may mean receiving the body bias voltage VBB from the body bias generator 150, and the normal operation circuit or use circuit, which is the second circuit 102, may mean receiving the power voltage VDD and the ground voltage VSS from the voltage generator or the outside.

The first circuit 101 may be connected to an end of the first switch SW5 and may be connected to an end of the second switch SW6.

One end of the first switch SW5 may be connected to the first node N1, and the other end thereof may be connected to the first circuit 101. The first switch SW5 may be turned on in response to a first logic level (e.g., a logic high level) of the fourth switch control signal SC4 (which may be an example of the first switch control signal in the appended claims). When the first switch SW5 is turned on, the first circuit 101 and the body bias generator 150 may be electrically connected to each other. For example, when the first switch SW5 is turned on, the body bias voltage VBB may be applied to the body terminals of the semiconductor devices 30 (see FIG. 3) of the first circuit 101. That is, the first node N1 may output the body bias voltage VBB.

One end of the second switch SW6 may be connected to the second node N2, and the other end thereof may be connected to the first circuit 101. The second switch SW6 may be turned on in response to the first logic level of the fourth switch inversion control signal SC4B (which may be an example of the second switch control signal in the appended claims). When the second switch SW6 is turned on, the first circuit 101 and the power supply voltage VDD and the ground voltage VSS may be electrically connected to each other. For example, when the second switch SW6 is turned on, the power supply voltage VDD and the ground voltage VSS may be applied to the semiconductor devices 30 of the first circuit 101. The power voltage VDD and the ground voltage VSS may be applied to the semiconductor devices 30 of the second circuit 102 through the second node N2.

Referring to FIG. 16, in the power-up mode, the fourth switch inversion control signal SC4B may be a first logic level (e.g., a logic high level), the fourth switch control signal SC4 may be a second logic level (e.g., a logic low level), and the first circuit 101 may have a logic level of the power supply voltage VDD and a logic level of the ground voltage VSS. In the normal operation mode, the fourth switch inversion control signal SC4B may be in the second logic level, the fourth switch control signal SC4 may be in the first logic level, and the first circuit 101 may have a logic level of the PMOS body bias voltage VBP and a logic level of the NMOS body bias voltage VBN. Here, the voltage level of the PMOS body bias voltage VBP may be higher than the voltage level of the power supply voltage VDD, and the voltage level of the NMOS body bias voltage VBN may be lower than the voltage level of the ground voltage VSS.

Referring to FIGS. 15 and 16 together, the first switch SW5 may be turned on in response to the first logic level of the fourth switch control signal SC4. In addition, the second switch SW6 may be turned on in response to the first logic level of the fourth switch inversion control signal SC4B. The first switch SW5 and the second switch SW6 may be alternately turned on. For example, when the first switch SW5 is turned on in response to the fourth switch control signal SC4, the second switch SW6 may be turned off. For example, when the second switch SW6 is turned on in response to the fourth switch inversion control signal SC4B, the first switch SW5 may be turned off.

In some implementations, when the first switch SW5 is turned on and the second switch SW6 is turned off, the first circuit 101 may receive the body bias voltage VBB output through the first node N1. For example, the plurality of semiconductor devices included in the first circuit 101 may receive the PMOS body bias voltage VBP and/or the NMOS body bias voltage VBN.

In some implementations, the PMOS body bias voltage VBP having a voltage level higher than the power supply voltage VDD may be applied to body terminals of the plurality of semiconductor devices of the first circuit 101, and the NMOS body bias voltage VBN having a voltage level lower than the ground voltage VSS may be applied thereto. That is, threshold voltages of the plurality of semiconductor devices included in the first circuit 101 may be adjusted by adjusting the PMOS body bias voltage VBP and the NMOS body bias voltage VBN. When the level of the PMOS body bias voltage VBP is set to be higher than the level of the power supply voltage VDD and the level of the NMOS body bias voltage VBN is set to be lower than the level of the ground voltage VSS, the leakage current flowing through the plurality of semiconductor devices of the first circuit 101 may decrease as the threshold voltage increases.

A leakage current flowing through the unused circuit or the memory cell array 125 may be reduced by adjusting the body bias voltage VBB. Therefore, data errors caused by a decrease in read or write current according to a leakage current during a read or write operation may be reduced.

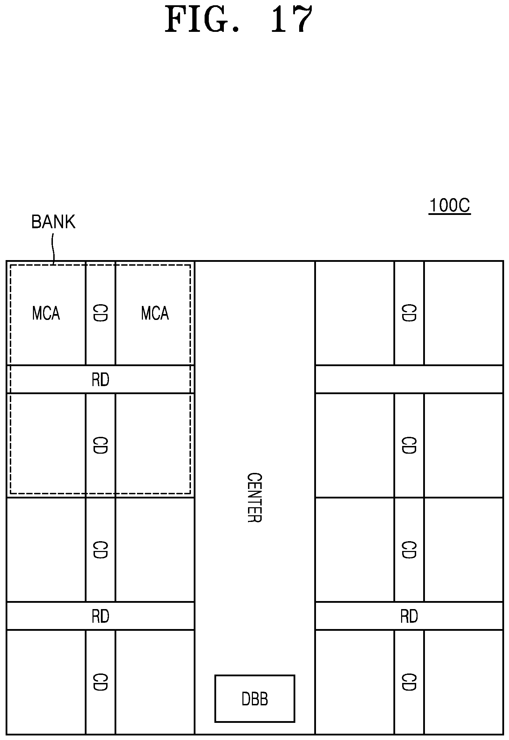

FIG. 17 is a diagram illustrating a semiconductor device 100C.

Referring to FIG. 17, the semiconductor device 100C may be a memory device and may include a plurality of unit memory regions. The memory device 100C may include a plurality of banks that are a plurality of unit memory regions. Each bank BANK may include memory cell arrays MCA, a row decoder RD, and column decoders CD.

The operation of the semiconductor device 100C may be controlled by a control logic. The control logic may store data received from the outside in each of the banks, or may read data from at least one of the plurality of banks based on address information received from the outside and output the read data to the outside. In addition, the control logic may include an input/output circuit for transmitting and receiving signals to and from an external device. Since a plurality of banks BANK are arranged on both sides based on the control logic, the control logic may allow wiring patterns connecting the input/output circuit of the control logic with pads to be efficiently designed by forming the semiconductor device 100C.

A center pad CENTER may include a dynamic body bias control circuit (DBB). The DBB may adjust body bias voltages of a plurality of semiconductor devices included in the semiconductor device 100C. The DBB may correspond to the body bias generator 150 illustrated in FIGS. 1 and 2.

In some implementations, the DBB may be used to dynamically adjust threshold voltages of the plurality of transistors included in the semiconductor device 100C or the memory device. For example, when a circuit or a memory device that does not operate in a normal operation mode other than the power-up mode of the memory device receives a specific data bit width, a body bias voltage may be applied to the circuit that does not operate. The body bias voltage may include a PMOS body bias voltage and an NMOS body bias voltage, a PMOS body bias voltage level may be set higher than a power supply voltage level, and an NMOS body bias voltage level may be set lower than a ground voltage level. The PMOS body bias voltage and the NMOS body bias voltage may be referred to as a reverse body bias voltage.

The DBB may reduce leakage current by setting a threshold voltage high by applying a reverse body bias voltage to a circuit that is not operating. For example, the DBB may reduce leakage current by applying a reverse body bias voltage to the body terminals of the semiconductor devices in a circuit that is not operating.

Therefore, the threshold voltages of at least some of the semiconductor devices may be changed and current characteristics may be adjusted by the body bias voltage controlled by the DBB. The DBB may adaptively adjust the body bias voltage output to the semiconductor devices.

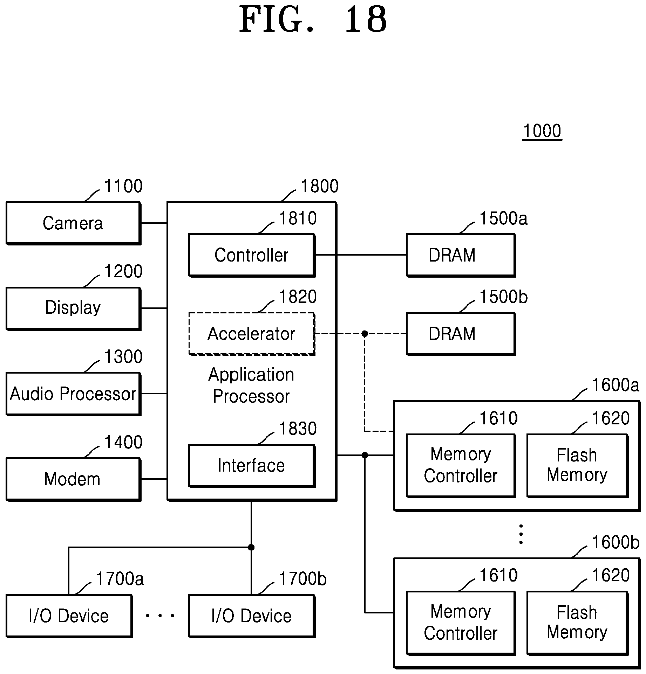

FIG. 18 is a diagram illustrating a system 1000 including an example memory device.

Referring to FIG. 18, the system 1000 may include a camera 1100, a display 1200, an audio processor 1300, a modem 1400, DRAMs 1500a and 1500b, flash memories 1600a and 1600b, I/O devices 1700a and 1700b, and an application processor (AP) 1800. The system 1000 may be implemented as a laptop computer, a mobile phone, a smartphone, a tablet PC, a wearable device, a healthcare device, or an IoT device. In addition, the system 1000 may be implemented as a server or a PC.

The camera 1100 may shoot a still image or a video image under control by a user and store the captured image/video data and transmit the stored data to the display 1200. The audio processor 1300 may process audio data included in the flash memories 1600a and 1600b or content of a network. The modem 1400 may modulate and transmit signals for wired/wireless data transmission and reception and demodulate the signals to recover the original signal at a receiving side. The I/O devices 1700a and 1700b may include devices that provide digital input and/or output functions such as a Universal Serial Bus (USB) or storage, digital cameras, Secure Digital (SD) cards, a Digital Versatile Disc (DVD), a network adapter, a touch screen, etc.

The AP 1800 may control the overall operation of the system 1000. The AP 1800 may include a controller block 1810, an accelerator block 1820, which may include an accelerator chip, and an interface block 1830. The AP 1800 may control the display 1200 so that some of the content stored in the flash memories 1600a and 1600b is displayed on the display 1200. When a user input is received through the I/O devices 1700a and 1700b, the AP 1800 may perform a control operation corresponding to the user input. The AP 1800 may include the accelerator block 1820, which is a dedicated circuit for processing Artificial Intelligence (AI) data, or may include the accelerator chip 1820 separately from the AP 1800. The DRAM 1500b may be additionally mounted on the accelerator block or the accelerator chip 1820. The accelerator chip 1820 is a function block that specializes in performing specific functions of the AP 1800, and the accelerator block may include a GPU, which is a function block that specializes in graphic data processing, a Natural Processing Unit (NPU), which is a block for specializing in AI calculation and Inference, and a Data Processing Unit (DPU), which is a block that specializes in data transmission.

The system 1000 may include a plurality of DRAMs 1500a and 1500b. The AP 1800 may control DRAMs 1500a and 1500b through command and mode register (MRS) settings that meet the Joint Electron Device Engineering Council (JEDEC) standards, or may configure a DRAM interface protocol for communication with DRAMs in order to use company-specific functions such as low voltage/high speed/reliability, and Cyclic Redundancy Check (CRC)/Error Correction Code (ECC) functions. For example, the AP 1800 may communicate with the DRAM 1500a through an interface that meets JEDEC standards such as LPDDR4, LPDDR5, and the like, and the accelerator block or accelerator chip 1820 may configure a new DRAM interface protocol for communication with the DRAMs, in order to control the DRAM 1500b for accelerators with higher bandwidth than the DRAM 1500a.

Although FIG. 18 shows only DRAMs 1500a and 1500b, the implementations are not limited thereto, and any memory such as PRAM, SRAM, MRAM, RRAM, FRAM, or hybrid RAM may be used if the bandwidth, reaction speed, and voltage conditions of the AP 1800 or the accelerator chip 1820 are satisfied. The DRAMs 1500a and 1500b have latencies and bandwidths that are relatively less than the I/O devices 1700a and 1700b or the flash memories 1600a and 1600b. The DRAMs 1500a and 1500b are initialized at the power-on time point of the system 1000 and used as a temporary storage location of the operating system and the application data when the operating system and the application data are loaded, or used as an execution space of various pieces of software code.

Within DRAMs 1500a and 1500b, the four fundamental arithmetic operations such as addition/subtraction/multiplication/division, vector operations, address operations, or Fast Fourier Transform (FFT) operations may be performed. In addition, within the DRAMs 1500a and 1500b, functions for performance used for inference may be performed. Here, inference may be performed in a deep learning algorithm using an artificial neural network. Deep learning algorithms may include a training operation of learning a model through a variety of data and an inference operation of recognizing data with a learned model. In some implementations, an image taken by a user through the camera 1100 is signal-processed and stored in the DRAM 1500b, and the accelerator block or accelerator chip 1820 may perform an AI data calculation that recognizes data using data and functions used for inference, which are stored in the DRAM 1500b.

The system 1000 may include storages or the flash memories 1600a and 1600b having capacities greater than the DRAMs 1500a and 1500b. The accelerator block or accelerator chip 1820 may perform training operations and AI data calculations using the flash memories 1600a and 1600b. In some implementations, the flash memories 1600a and 1600b include a memory controller 1610 and a flash memory device 1620, and a training operation and an inference AI data calculation performed by the AP 1800 and/or the accelerator chip 1820 may be performed more efficiently using a calculation device provided in the memory controller 1610. The flash memories 1600a and 1600b may store photos taken through the camera 1100 or may store data transmitted to the data network. For example, augmented reality/virtual reality, high definition (HD), or ultrahigh definition (UHD) content may be stored.

In the system 1000, the DRAMs 1500a and 1500b may include the memory device described with reference to FIGS. 1 to 17. The memory device may include a function circuit and a body bias generator. The function circuit may include a PMOS and/or an NMOS, which are a plurality of semiconductor devices. The body bias generator may apply a body bias voltage to body terminals of the plurality of semiconductor devices. The body bias voltage may include a PMOS body bias voltage and an NMOS body bias voltage. The body bias generator may set a PMOS body bias voltage level to be higher than the power voltage level, and may set an NMOS body bias voltage level to be lower than the ground voltage level. That is, the body bias generator may reduce the leakage current of the memory device by adjusting the body bias voltage applied to the plurality of semiconductor devices included in the function circuit.

The memory device described in this disclosure may dynamically adjust the body bias voltage, and may reduce leakage current flowing through the memory device by adjusting the body bias voltage.

While this disclosure contains many specific implementation details, these should not be construed as limitations on the scope of what may be claimed. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

While the memory device has been particularly shown and described with reference to implementations thereof, it will be understood that various changes in form and details may be made therein without departing from the scope of the following claims.

## Claims

1. A memory device comprising:
a function circuit (300) including a plurality of semiconductor devices (30); and
a body bias generator (150) configured to provide body bias voltages (VBB) to body terminals of the plurality of semiconductor devices (30), wherein the function circuit (300) comprises:
a first circuit (101);
a second circuit (102); and
a first switch (SW1; SW5) and a second switch (SW3; SW6), wherein
the first switch (SW1; SW5) is connected between the first circuit (101) and a first node (N1) to which the body bias voltage is applied,
the second switch (SW3; SW6) is connected between the first circuit (101) and a second node (N2) to which a supply voltage (VDD) is applied, and
the second circuit (102) is connectable or connected to the second node (N2).

2. The memory device according to claim 1, wherein the function circuit (300) further comprises:
a third switch (SW2) and a fourth switch (SW4), wherein
the third switch (SW2) is connected between the second circuit (102) and the first node (N1), and
the fourth switch (SW4) is connected between the second circuit (102) and the second node (N2).

3. The memory device of claim 2, wherein the plurality of semiconductor devices (30) include a P-type transistor (10) and an N-type transistor (20).

4. The memory device of claim 2 or 3, wherein the body bias generator (150) comprises:
a charge pump (151) configured to provide the body bias voltages (VBB) to each of the body terminals of the plurality of semiconductor devices (30); and
a signal generation circuit (152) configured to generate a switch control signal (S_CTRL) for controlling the first to fourth switches (SW1 to SW4).

5. The memory device of claim 4, wherein the charge pump (151) is configured to:
provide a positive body bias voltage (VBP) to a body terminal of the P-type transistor (10); and
provide a negative body bias voltage (VBN) to a body terminal of the N-type transistor (20).

6. The memory device of any one of claims 2 to 5, wherein the body bias generator (150) is configured to:
increase a positive body bias voltage (VBP) level provided to a body terminal of the P-type transistor (10); and
reduce a negative body bias voltage (VBN) level provided to a body terminal of the N-type transistor (20).

7. The memory device of any one of claims 4 to 6, wherein the switch control signal (S_CTRL) includes a first switch control signal (SC1), a second switch control signal (SC2), and a third switch control signal (SC3).

8. The memory device of claim 7, wherein the third switch (SW2) and the second switch (SW3) are configured to be turned on based on the first switch control signal (SC1) being in a high state, so as to provide the body bias voltage (VBB) to body terminals of the plurality of semiconductor devices (30) included in the second circuit (102).

9. The memory device of claim 7 or 8, wherein the first switch (SW1) and the fourth switch (SW4) are configured to be turned on based on the second switch control (SC2) signal being in a high state, so as to provide the body bias voltage (VBB) to body terminals of the plurality of semiconductor devices (30) included in the first circuit (101).

10. The memory device of any one of claims 7 to 9, wherein the second switch (SW3) and the fourth switch (SW4) are configured to be turned on based on the third switch control signal (SC3) being in a high state, so as to provide the supply voltage (VDD) to a plurality of semiconductor devices (30) included in the first circuit (101) and a plurality of semiconductor devices (30) included in the second circuit (102).

11. The memory device of claim 1, wherein
the second circuit (102) is connected to the second node (N2),
the first circuit (101) operates only in a power-up mode operation,
the second circuit (102) is configured to operate in a normal mode operation including the power-up mode, and
the plurality of semiconductor devices (30) include a PMOS device and an NMOS device.

12. The memory device of claims 1 or 11, wherein the second circuit (102) is connected to the second node (N2), and wherein the body bias generator (150) comprises:
a charge pump (151) configured to provide the body bias voltage (VBB) to each of the body terminals of the plurality of semiconductor devices (30); and
a signal generation circuit (152) configured to generate a switch control signal (S_CTRL) for controlling the first and second switches (SW5, SW6).

13. The memory device of claim 12, wherein
the switch control signal (S_CTRL) comprises a first switch control signal (SC4) and a second switch control signal (SC4B), and
the first switch control signal (SC4) and the second switch control signal (SC4B) are complementary.

14. The memory device of claim 12 or 13, wherein
the body bias voltage (VBB) comprises a positive body bias voltage (VBP) and a negative body bias voltage (VBN), and
the positive body bias voltage (VBP) is applied to a PMOS device body terminal, and the negative body bias voltage (VBN) is applied to an NMOS device body terminal.

15. The memory device of any one of claims 1 to 14, further comprising:
a training circuit (110) configured to perform a training operation;
a test mode register, TMRS, (120) configured to store test operation information; and
a memory cell array (125) including a plurality of memory cells, wherein the first circuit (101) includes the training circuit (110) or the TMRS (120), and the second circuit (102) includes the memory cell array (125).
